## Europäisches Patentamt

## European Patent Office

## Office européen des brevets

(11) Veröffentlichungsnummer: **0 355 296**
**A2**

# EUROPÄISCHE PATENTANMELDUNG

(21) Anmeldenummer: **89110897.9**

(22) Anmeldetag: **15.06.89**

(51) Int. Cl.⁴: **C23C 16/18 , C01G 41/00**

(30) Priorität: **18.08.88 DE 3828125**

(43) Veröffentlichungstag der Anmeldung:
**28.02.90 Patentblatt 90/09**

(84) Benannte Vertragsstaaten:
**AT BE CH DE FR GB IT LI NL SE**

(71) Anmelder: **Siemens Aktiengesellschaft**
**Wittelsbacherplatz 2**
**D-8000 München 2(DE)**

(72) Erfinder: **Kruck, Thomas, Prof. Dr.**
**Am Wachberg 9**
**D-5042 Erfstadt(DE)**
Erfinder: **Behrendorf, Norbert, Dip.-Chem.**
**An der Pulvermühle 18**
**D-5000 Köln(DE)**
Erfinder: **Faubel, Heiko, Dr.**
**Borger Strasse 29a**
**D-5632 Wermelskirchen(DE)**

(54) CVD-taugliche Wolframhalogenphosphankomplexverbindungen sowie Verfahren zu ihrer Herstellung.

(57) Die Erfindung betrifft Wolframhalogenphosphan-komplexverbindungen mit der Formel $W(PX_3)_{6-n}L_n$ in der X = Fluor oder Chlor, L = molekularer Stickstoff, Aceton oder andere Ketone oder Aldehyde, Kohlenmonoxid, Acetonitril oder andere Nitrile, Diphenylethin oder andere Ehtine, Diethylether oder Tetrahydrofuran oder andere offenkettige oder cyclische Ether, Benzol oder andere Aromaten, Ethen oder 1,5-Cyclooktadien oder Cycloheptatrien oder andere Mono-, Di- bzw. Trioloefine sind, wobei zwei einzähnige Liganden L durch einen $\eta^4$ Liganden ersetzt sein können oder drei einzähnige Liganden L durch einen $\eta^6$-Liganden und n eine ganze Zahl von 0 bis 5 ist, sowie Verfahren zu ihrer Herstellung. Diese Stoffe sind im Vakuum leicht flüchtig und bei sehr niedrigen Temperaturen zersetzbar und daher sehr gut geeignet für CVD-Abscheidungen in der Halbleitertechnik, insbesondere als Kontaktlochfüller bei höchstintegrierten Schaltungen.

### CVD-taugliche Wolframhalogenphosphankomplexverbindungen sowie Verfahren zu ihrer Herstellung.

Die Erfindung betrifft neuartige CVD-taugliche Wolframhalogenphosphankomplexverbindungen sowie deren Synthesen.

Die metallorganische und die Koordinationschemie haben in den letzten Jahrzehnten vor allem durch ihre stetig wachsende technische Bedeutung einen gewaltigen Aufschwung erfahren. Die häufige Anwendung in der organischen Synthese, die Stabilisierung reaktiver Teilchen wie zum Beispiel Arine, Carbene, Alkine durch Metallkoordination und die homogene Katalyse über Organometallzwischenstufen stellen drei eindrucksvolle Beispiele für die breitgefächerte Nutzung metallorganischer Spezies dar. Ein hochaktuelles Beispiel ist die Metallabscheidung aus diesen Verbindungen mittels CVD-Verfahren (=chemical vapor deposition). Dazu werden Metallkomplexe benötigt, die leicht flüchtig und thermisch zersetzbar sind.

Aus der Zeitschrift "Angewandte Chemie" 79 ist aus einem Aufsatz von Th. Kruck auf den Seiten 27 bis 43 (1967) die Reindarstellung des anorganischen Liganden Trifluorphosphan bekannt. Es wurde festgestellt, daß bei dieser Verbindung eine im Vergleich zu den bereits bekannten Übergangsmetall-Carbonylen stärkere $\pi$-Akzeptorfähigkeit am Liganden PF$_3$ vorliegt.

Die Verbindung Hexakis(trifluorphosphan)-Wolfram(O) mit der chemischen Formel W(PF$_3$)$_6$ ist aus einem weiteren Aufsatz von Th. Kruck et. al. aus der Zeitschrift "Anorganische Allgemeine Chemie" 397 auf den Seiten 31 bis 39 (1973) zu entnehmen. Diese Verbindung wurde nach dem Verfahren der "reduktiven Fluorphosphanierung" in 42 %iger Ausbeute dargestellt.

Aus der deutschen Offenlegungsschrift 1 900 119 ist auch be reits die Verwendung von Metalltrifluorphosphanen bekannt. Dabei werden durch thermische Zersetzung von damals bekannten Metall(O)-Komplexen und deren Hydrido-Derivaten bei Temperaturen von 350 bis 600° C und vermindertem Druck Metallschichten auf Substrate abgeschieden, die als Kontaktmetallschichten in der Halbleitertechnik verwendbar sind.

Aufgabe der Erfindung ist es, neue Verbindungstypen aus der Koordinationschemie von Wolfran(O) mit Halogenphosphan-Liganden (PF$_3$ bzw. PCl$_3$) ohne bzw. mit zusätzlichen Liganden L bereitzustellen, die für Metallisierungen in der Halbleitertechnik, insbesondere als Kontaktlochfüller bei höchstintegrierten Schaltungen, geeignet sind. Eine weitere Aufgabe der Erfindung ist es, ihre Synthesen anzugeben. Wichtig ist, daß die Zersetzung dieser Verbindungen bei möglichst niedrigen Temperaturen möglich ist.

Die Erfindung ist gekennzeichnet durch Wolframhalogenphosphankomplexverbindungen mit der Formel W(PX$_3$)$_{6-n}$L$_n$ in der X = Fluor oder Chlor, L = molekularer Stickstoff (N$_2$), Aceton ((CH$_3$)$_2$CO) oder andere Ketone oder Aldehyde, Kohlenmonoxid (CO), Acetonitril (CH$_3$CN) oder andere Nitrile, Diphenylethin (C$_6$H$_5$C $\equiv$ CC$_6$H$_5$) oder andere Ethine, Diethylether (Et$_2$O) oder Tetrahydrofuran (THF) oder andere offenkettige oder cyclische Ether, Benzol (C$_6$H$_6$) oder andere Aromaten, Ethen (C$_2$H$_4$) oder 1,5-Cyclooktadien (COD) oder Cycloheptatrien (CHT) oder andere Mono-, Di- bzw. Triolefine sind, wobei zwei einzähnige Liganden L durch einen $\eta^4$-Liganden ersetzt sein können oder drei einzähnige Linganden L durch einen $\eta^6$ Liganden und n eine ganze Zahl von 0 bis 5 ist.

Weitere besonders bevorzugte Verbindungen sowie deren Synthesen ergeben sich aus den Unteransprüchen.

Wegen ihrer leichten Flüchtigkeit im Vakuum und wegen ihrer leichten thermischen Zersetzlichkeit bei sehr niedrigen Temperaturen (einige Verbindungen zersetzen sich bereits zwischen 50 und 100° C) sind diese Verbindungen bestens geeignet für das homogene Auffüllen von in Isolationsschichten geätzten Kontakt löchern mit Wolfram wie es bei der Herstellung von höchstintegrierten Speicherschaltungen gefordert wird. Diese Verwendungen können sowohl für das thermische CVD als auch für das plasmainduzierte CVD verwendet werden; auch der Einsatz von Laser-CVD ist möglich.

Zur näheren Erläuterung der Erfindung dienen nachfolgend einige Ausführungsbeispiele, wobei sich die Synthesen 1 bis 3 auf die Darstellung von Hexakis(trifluorphosphan)wolfram, W(PF$_3$)$_6$, beziehen und die Synthesen 4 bis 8 auf die Darstellung von W(PF$_3$)$_6$-Derivaten der Formel (W(PF$_3$)$_{6-n}$L$_n$ (n = 1 bis 5). Letztere zeichnen sich oftmals durch eine große Flüchtigkeit im Vakuum und eine geringe chemische und thermische Stabilität relativ zu W(PF$_3$)$_6$ aus.


1. Ausführungsbeispiel

In einer Innenbestrahlungsapparatur werden 2 g W(CO)$_6$ in 260 ml Pentan und 10 ml Mesitylen gelöst und auf - 50° C abgekühlt. Nach Sättigung mit PF$_3$ wird fünf Tage mit einem Hg-Hochdruckbrenner bestrahlt, wobei mehrmals mit PF$_3$ nachgesättigt wird. Nach abziehen des Lösungsmittels bei Raumtemperatur wird das Produkt bei - 30° C aus dem verbleibenden Mesitylen auskristallisiert und bei 40° C/10$^{-2}$ mbar sublimiert. Man erhält 0,5 g farblose Kristalle.

### 2. Ausführungsbeispiel

In einen Rotierautoklaven, gefüllt mit 6 g PPN-$[W(PF_3)_5Cl]$ (PPN = Bis(triphenylphosphan)-nitrogenium) wird bei - 196° C soviel $PF_3$ einkondensiert, daß sich bei Raumtemperatur ein Druck von 200 bar einstellt. Der Autoklav wird bei 150° C drei bis vier Tage in einem heizbaren Rührstand rotiert. Nach Ende der Reaktionszeit wird der Inhalt in ein auf - 196° C gekühltes Schlenkenrohr gebracht. Das überflüssige $PF_3$ wird langsam abkondensiert. Sublimation des Rückstandes bei 50° C im Hochvakuum.

### 3. Ausführungsbeispiel

5 g $PPN[W(PF_3)_5Cl]$ werden in 100 ml Ether gelöst, auf - 50° C abgekühlt, mit $PF_3$ gesättigt und portionsweise mit 1 g $AlCl_3$ versetzt. Das Lösungsmittel wird abgezogen und das erhaltene Produkt bei 50° $C/10^{-2}$ mbar sublimiert. Man erhält 1 g farblose Kristalle.

### 4. Ausführungsbeispiel

Herstellung des Komplexes $W(PF_3)_5N_2$.

In einer Außenbestrahlungsapparatur werden 0,6 g $W(PF_3)_6$ in 120 ml frisch destilliertem Ether (ohne Stabilisator) gelöst und die Lösung auf - 15° C abgekühlt. Unter Durchleiten eines schwachen Stickstoffstroms wird zwei Stunden bestrahlt. Unter Beibehaltung des Stickstoffstroms wird noch eine Stunde bei - 15° C gerührt und die Lösung langsam auf Raumtemperatur gebracht. Das Lösungsmittel wird im Vakuum abgezogen. Das gelbbraune Öl wird in Pentan gelöst und filtriert. Das nach Entfernen des Lösungsmittels erhaltene Produkt wird gereinigt, indem es zweimal in je 10 ml Pentan gelöst und dann bei - 78° C ausgefällt wird. Die so gebildeten Kristalle werden bei 50° $C/10^{-3}$ mbar sublimiert. Man erhält 240 mg hellgelbe Kristalle.

### 5. Ausführungsbeispiel

Herstellung des Komplexes $W(PF_3)_5(CH_3)_2CO$.

0,5 g $W(PF_3)_6$ werden in 120 ml Ether gelöst und in einer Quarzaußenbestrahlungsapparatur bei - 15° C zwei Stunden bestrahlt, wobei der Lösungsmittelkomplex $W(PF_3)_5 OEt_2$ entsteht. Anschließend wird 1 ml Aceton zugegeben und auf Raumtemperatur aufgetaut. Nach Rühren über Nacht wird das Lösungsmittel abgezogen und das Produkt bei 30° $C/10^{-2}$ mbar sublimiert. Man erhält 200 mg gelbe Kristalle.

### 6. Ausführungsbeispiel

Herstellung des Komplexes $W(PF_3)_5CO$.

2 g $(W(CO)_6$ werden in einer Glasinnenbestrahlung in 260 ml Pentan und 10 ml Mesitylen gelöst und auf - 50° C abgekühlt. Nach Sättigung mit $PF_3$ wird fünf Tage bestrahlt, wobei mehrmals mit $PF_3$ nachgesättigt wird. Nach Abziehen des Lösungsmittels wird das Produkt bei - 30° C aus dem verbleibenden Mesitylen auskristallisiert und bei 20° $C/10^{-2}$ mbar sublimiert. Man erhält 0,5 g farblose Kristalle.

### 7. Ausführungsbeispiel

Herstellung des Komplexes $W(PF_3)_4(\eta^4-L)$ mit L = 1.5-Cyklooctadien (COD).

0.7 g $W(PF_3)_6$ werden in einer Quarzaußenbestrahlungsapparatur in 80 ml Pentan und 20 ml 1.5-COD gelöst und bei - 5° C eine Stunde bestrahlt. Nach Abziehen des Lösungsmittels bei Raumtemperatur und Abdestillieren des COD bei 50° $C/10^{-2}$ Torr wird das Produkt bei 80° $C/10^{-2}$ mbar sublimiert. Man erhält 150 mg gelbe Kristalle.

### 8. Ausführungsbeispiel

Herstellung des Komplexes $W(PF_3)_3(\eta^6-L)$ mit L = Benzol $(C_6H_6)$.

0,4 g $W(PF_3)_6$ werden in einer Quarzaußenbestrahlungsapparatur in 100 ml Benzol und 20 ml Pentan gelöst und bei 0° C dreißig Minuten bestrahlt. NAch Abziehen des Lösungsmittels und Abdestillieren des Benzols im Hochvakuum wird das Produkt bei 80° $C/10^{-2}$ mbar sublimiert. Man erhält 120 mg gelbe Kristalle.

### Ansprüche

1. CVD-taugliche Wolframhalogenphosphankomplexverbindungen mit der Formel
$W(PX_3)_{6-n}L_n$ in der
X = Fluor oder Chlor,

L = molekularer Stickstoff ($N_2$), Aceton (($CH_3)_2CO$) oder andere Ketone oder Aldehyde, Kohlenmonoxid (CO), Acetonitril ($CH_3CN$) odere andere Nitrile, Diphenylethin ($C_6H_5C \equiv CC_6H_5$) oder andere Ethine, Diethylether ($Et_2O$) oder Tetrahydrofuran (THF) oder andere offenkettige oder cyclische Ether, Benzol ($C_6H_6$) oder andere Aromaten, Ethen ($C_2H_4$) oder 1,5-Cyclooktadien (COD) oder Cycloheptatrien (CHT) oder andere Mono-, Di- bzw. Triolefine sind, wobei zwei einzähnige Liganden L durch einen $\eta^4$-Liganden ersetzt sein können oder drei einzähnige Liganden L durch einen $\eta^6$-Liganden und n = eine ganze Zahl von 0 bis 5.

2. Wolframhalogephosphanverbindung nach Anspruch 1, **dadurch gekennzeichnet,** daß X - Fluor und n = 0.

3. Wolframhalogenphosphanverbindung nach Anspruch 1, **dadurch gekennzeichnet,** daß X = Chlor und n = 0.

4. Wolframhalogenphosphanverbindung nach Anpsruch 1, **dadurch gekennzeichnet,** daß X = Fluor, n = 1 und L = Stickstoff ($N_2$).

5. Wolframhalogenphosphanverbindung nach Anspruch 1, **dadurch gekennzeichnet,** daß X = Fluor, n = 1 und L = Aceton (($CH_3)_2CO$).

6. Wolframhalogenphosphanverbindung nach Anspruch 1, **dadurch gekennzeichnet,** daß X = Fluor, n = 1 und L = Kohlenmonoxid (CO).

7. Wolframhalogenphosphanverbindung nach Anspruch 1, **dadurch gekennzeichnet,** daß X = Fluor, n = 2 und $L_2$ = 1.5-Cyclooctadien, Norbornadien oder andere Diene.

8. Wolframhalogenphosphanverbindung nach Anspruch 1, **dadurch gekennzeichnet,** daß X = Fluor, n = 3 und $L_3$ = $\eta^6$-Aren wie Benzol, Toluol, Mesitylen.

9. Wolframhalogenphsophanverbindung nach Anspruch 1, **dadurch gekennzeichnet,** daß X = Fluor, n = 3 und $L_3$ = $\eta^6$-Trien wie Cycloheptatrien.

10. Verfahren zum Herstellen von Hexakis-(trifluorphosphan)wolfram mit der Formel $W(PF_3)_6$ nach Anspruch 2, **dadurch gekennzeichnet,** daß Wolframhexacarbonyl mit Trifluorphosphan photochemisch umgesetzt wird.

11. Verfahren zum Herstellen von Hexakis-(trifluorphosphan) wolfram mit der Formel $W(PF_3)_6$ nach Anspruch 2, **dadurch gekennzeichnet,** daß anionische $[W(PF_3)_5X]^{\ominus}$-Komplexe, wobei X = Halogenid, unter Druck mit Kupferpulver und Trifluorphosphin umgesetzt wird.

12. Verfahren nach Anspruch 11, **dadurch gekennzeichnet,** daß anstelle von $[W(PF_3)_5X]^{\ominus}$-Komplexen Wolframsulfid ($WS_2$) verwendet wird.

13. Verfahren zum Herstellen von Hexakis-(trifluorphosphan)wolfram mit der Formel ($W(PF_3)_6$ nach Anspruch 2, **dadurch gekennzeichnet,** daß $[W(PF_3)_5X]^{\ominus}$-Komplexe in Gegenwart von Trifluorphosphan mit einer Lewis-Säure umgesetzt werden.

14. Verfahren zum Herstellen von Hexakis-(trifluorphosphan)wolfram mit der Formel ($W(PF_3)_6$ nach Anspruch 2, **dadurch gekennzeichnet,** daß Wolframhalogenide durch Magnesium-Anthracen unter $PF_3$-Druck reduziert werden.

15. Verfahren zum Herstellen von Derivaten des Hexakis(trifluorphosphan)wolfram der Formel $W(PF_3)_{6-n}L_n$ (n = 1 bis 5) nach einem der Ansprüche 4 bis 9, **dadurch gekennzeichnet,** daß Hexakis(trifluorphosphan)wolfram mit dem betreffenden Liganden photochemisch umgesetzt wird.

16. Verfahren zum Herstellen von Derivaten des Hexakis(trifluorphosphan)wolfram der Formel $W(PF_3)_{6-n}L_n$ (n = 1 bis 5) nach einem der Ansprüche 4 bis 9, **dadurch gekennzeichnet,** daß ein Wolframtrifluorphosphan-Komplex der Formel $W(PF_3)_{6-n}L_n$ mit anderen $L'$ zu einem $W(PF_3)_{6-n}L'_n$-Komplex thermisch und/oder unter Druck umgesetzt wird.

17. Verfahren zum Herstellen von Derivaten des Hexakis(trifluorphosphan)wolfram der Formel ($W(PF_3)_{6-n}L_n$ mit n = 1 bis 5 nach einem der Ansprüche 4 bis 9, **dadurch gekennzeichnet,** daß ein Wolframcarbonylkomplex der Formel $W(CO)_{6-n}L_n$ mit n = 0 bis 4 mit Trifluorphosphan photochemisch umgesetzt wird.